## Europäisches Patentamt
## European Patent Office
## Office européen des brevets

(11) Numéro de publication: **0 148 703**
**B1**

(12) **FASCICULE DE BREVET EUROPÉEN**

(45) Date de publication du fascicule du brevet:
**03.02.88**

(51) Int. Cl.⁴: **G 01 J 5/20, H 01 L 31/08**

(21) Numéro de dépôt: **84402734.2**

(22) Date de dépôt: **27.12.84**

(54) Procédé de compensation en température d'un détecteur photoconducteur.

(30) Priorité: **03.01.84 FR 8400030**

(43) Date de publication de la demande:
**17.07.85 Bulletin 85/29**

(45) Mention de la délivrance du brevet:
**03.02.88 Bulletin 88/5**

(84) Etats contractants désignés:
**DE GB SE**

(56) Documents cité:
**FR-A-1 451 231**
**FR-A-2 027 100**
**US-A-3 629 585**

**PATENTS ABSTRACTS OF JAPAN, vol. 2, no. 26, 20 février 1978, page 11789 E 77**

(73) Titulaire: **THOMSON-CSF, 173, Boulevard Haussmann, F-75379 Paris Cédex 08 (FR)**

(72) Inventeur: **Moy, Jean-Pierre, THOMSON-CSF SCPI - 173, bld Haussmann, F-75379 Paris Cedex 08 (FR)**

(74) Mandataire: **Ruellan-Lemonnier, Brigitte, THOMSON-CSF SCPI 19, avenue de Messine, F-75008 Paris (FR)**

## Description

La présente invention concerne les détecteurs photoconducteurs. De tels détecteurs sont largernent utilisés en opto-électronique pour la détection d'un rayonnernent électrornagnétique, notamment la détection d'un rayonnement électrornagnétique dont la longueur d'onde se situe dans le domaine de la lumière visible et surtout de l'infra-rouge.

On rappelera tout d'abord que les détecteurs photoconducteurs exploitent l'augmentation de conductivité électrique d'un semiconducteur lorsque celui-ci est soumis à un éclairement par un rayonnement électromagnétique tel que défini ci-dessus. On observe donc, lorsque le détecteur est soumis à un tel éclairement, une augmentation du nombre de porteurs libres das la bande de conduction. Or, le nombre de porteurs libres est proportionnel à $\exp \frac{-EG}{kT}$

avec: E l'énergié de la bande intérdite

k la constante de Boltzmann, et

T la température

On voit donc que le nombre des porteurs dépend aussi de la température. En conséquence, une variation de la température ambiante entraîne une variation du nombre des porteurs dans la bande de conduction au même titre qu'un éclairement par un rayonnement électromagnétique. La variation en porteurs due à la température devient très vite équivalente à celle due à un éclairement, notamment dans le cas des semiconducteurs à bande interdite faible. Dans ce cas, en effet la variation du nombre de porteurs dans la bande de conduction par rapport au nombre de porteurs déjà présents est faible. Toutefois, la variation due à la température est une variation qui évolue lentement dans le temps. Aussi pour pouvoir distinguer les variations du nombre des porteurs dues à la température de celles dues à l'éclairement, on réalise une modulation de l'éclairement et on détecte donc en sortie un signal utile modulé.

Toutefois, ce problème de variation du nombre des porteurs due à la température est très important lorsque l'on désire détecter un signal continu, à savoir lorsqu'il est impossible de moduler l'éclairement.

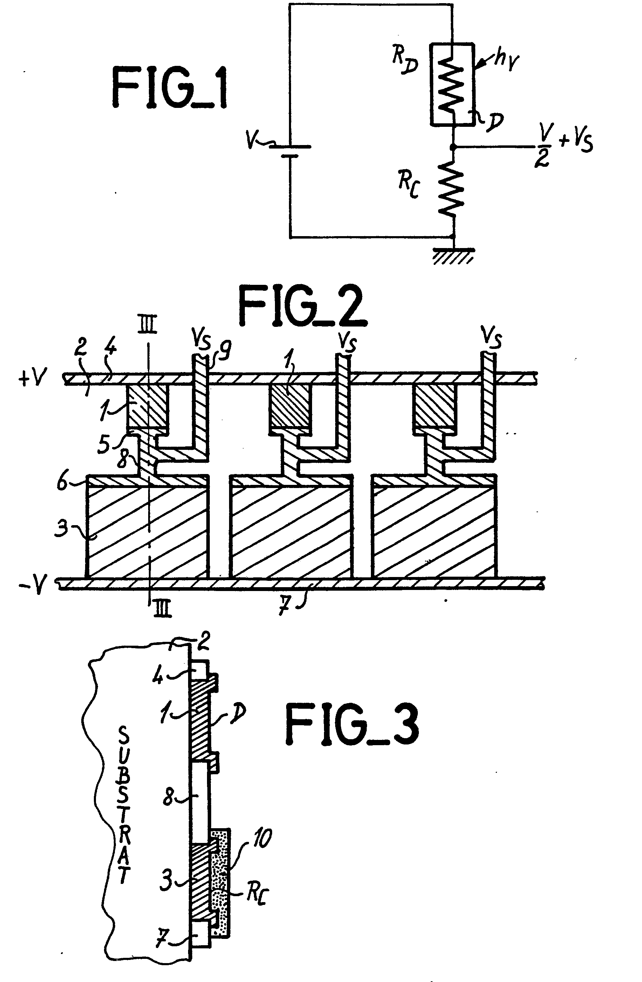

Avec les détecteurs photoconducteurs on utilise de préférence le circuit représenté à la figure 1 pour lire le signal utile correspondant à l'éclairement reçu. Ce circuit comporte une source de tension V aux bornes de laquelle sont montés en série le détecteur photoconducteur D constitué par un volume de semiconducteur avec deux contacts ohmiques et une résistance de charge Rc. Le signal utile est détecté aux bornes de la résistance de charge.

Avec ce type de montage, le signal utile est superposé à une tension qui est souvent bien plus grande que ledit signal et si l'on désire détecter un signal continu, on doit soustraire cette tension, ce qui suppose une grande stabilité de celle-ci.

Or, lorsque la température change, on observe dans le détecteur photoconducteur une variation du nombre de porteurs comme expliqué ci-dessus, c'est-à-dire une variation de la résistivité qui est inversement proportionnelle au nombre de porteurs libres et en conséquence une variation de la résistance du détecteur qui varie exponentiellement selon une loi proche de $\exp \frac{-EG}{kT}$ alors que la aésistance de charge a une variation négligeable en fonction de la température.

La présente invention a donc pour but de permettre la lecture d'un signal continu tout en remédiant à cet inconvénient.

La présente invention a en conséquence pour objet un procédé de compensation en température d'un détecteur photoconducteur lu en tension par l'intermédiaire d'une résistance de charge montée en série avec ledit déteteur caractérisé en ce qu'on réalise la résistance de charge sous forme d'un volume de même matériau que le détecteur, à proximité de celui-ci, et en ce qu'on la recouvre d'un cache isolant paque au rayonnement électromagnétique à détecter.

Dans ce cas, la résistance de charge présente la même variation en température que le détecteur. Celle-ci étant de plus contigüe au détecteur, la tension du point milieu est donc indépendante de la température.

Toutefois, lorsqu'un élément est réalisé dans un matériau semiconducteur, on observe deux types de bruits, à savoir le bruit Johnson qui est indépendant du matériau et le bruit de génération-recmbinaison dont la puissance moyenne est inversement proportionnelle au volume de semiconducteur considéré. En fait, l'épaisseur du déteteur étant généralement choisie égale à la longueur d'absorption du rayonnement électromagnétique à détecter, le détecteur est réalisé en couche mince et la tension de bruit de génération-recombinaison gênante est inversement proportionnelle à la racine carrée de la surface du détecteur.

En conséquence, si la résistance de charge à la même taille que le détecteur, elle apporte le même bruit et on dégrade la détectivité du détecteur d'un facteur $\sqrt{2}$. En conséquence, selon une autre caractéristique de la présente invention, la surface de la résistance de charge est obtenué par une transformation homothétique croissante de la surface du détecteur photoconducteur, de manière à apporter un excedent de bruit négligeable devant celui du déteteur seul. Par exemple, si la surface de la résistance de charge est quatre fois plus grande que celle du détecteur, la détectivité n'est dégradée que d'un facteur $\sqrt{1 + \frac{1}{4}} = 1,22$.

D'autres caractéristiques et avantages de la présente invention apparaîtront à la lecture de la description faite ci-après avec référence au dessin ci-annexé dans lequel:

- la figure 1, déjà décrite, est un schéma életrique d'un détecteur photoconducteur lu en tension;

- la figure 2 est une vue de dessus d'une partie d'une barrette de détecteurs photoconducteurs

compensés en température conformement à la présente invention;

- la figure 3 est une vue en coupe par HIII-HIII de figure 2.

La présente invention sera décrite de manière plus détaillée en se référant à des détecteurs photoconducteurs réalisés en couche mince et notamment à des détecteurs réalisés, par exemple, en sulfure de plomb, séléniure de plomb, sulfure de cadmium, séléniure de cadmium ou avec des composes ternaires tels que le sulfure de cadmium et de plomb, etc...

Comme représenté sur les figures 2 et 3, trois détecteurs photoconducteurs 1 en sulfure de plomb, par exemple, ont été réalisés sur un substrat 2 en verre ou en céramique, en utilisant la technologie des couches minces.

Chaque détecteur est constitué, à titre illustratif par un carré de 100 µm de coté et présente une épaisseur sensiblement égale à la longueur d'absorption du rayonnement électromagnétique à détecter. Conformément à la présente invention une résistance de charge 3 contigüe à chaque détecteur 1 est réalisée dans le même matériau que ce dernier. De ce fait, la résistance de charge varie en fonction de la température comme la résistance interne du détecteur photoconducteur 1. D'autre part, la surface de la résistance de charge 3 se déduit par homothétie de la surface du détecteur 1 et est constituée, dans le présent cas par un carré dont le coté présente, une longueur double de celle du carré formant le détecteur. Des contacts métalliques 4 à 7 sont prévus de chaque coté du détecteur et de la résistance de charge qui sont montés en série par un conducteur métallique 8, le signal utile étant obtenu sur le conducteur métallique 9 relié au conducteur 8. De préférence, les contacts 4 et 7 sont portés à des tension + V et - V de manière à s'affranchir des dérives de la tension d'alimentation.

D'autre part, comme représenté de manière plus détaillée sur la figure 3, un cache 10 en un matériau isolant et opaque au rayonnement à transmettre recouvre la résistance de charge. Le cache peut être réalisé par une couche d'oxyde de silicium recouverte d'une couche métallique telle que de l'aluminium ou bien le cache peut être réalisé en utilisant une encre de sérigraphie.

En utilisant une résistance de charge réalisée dans le même matériau que le détecteur et présentant une surface plus grande, on obtient donc une compensation en température du détecteur sans dégrader ses performances au niveau du bruit de géneration-recombinaison rajouté, comme expliqué dans l'introduction.

Dans le cas décrit ci-dessus, le détecteur photoconducteur et sa résistance de charge associée sont réalisés en utilisant l'un quelconque des procédés de réalisation des détecteurs photoconducteurs en couche mince.

## Revendications

1. Un procédé de compensation en température d'un détecteur photoconducteur lu en tension par l'intermédiaire d'une résistance de charge montée en série avec ledit détecteur caractérisé en ce qu'on réalise la résistance de charge sous forme d'un volume de même matériau que le détecteur, à proximité de celui-ci, et en ce qu'on la recouvre d'un cache isolant opaque au rayonnement électromagnétique à détecter.

2. Un procédé selon la revendication 1 caractérisé en ce que la valeur de la résistance de charge est égale à la valeur de la résistance interne du détecteur.

3. Un procédé selon l'une quelconque des revendications 1 ou 2 caractérisé en ce que la surface de la résistance de charge est obtenue par transformation homothétique croissante de la surface du détecteur photoconducteur.

4. Un procédé selon l'une quelconque des revendications 1 à 3 caractérisé en ce qu'on réalise simultanément le détecteur et sa résistance de charge en utilisant la technique des couches minces.

## Patentansprüche

1. Temperaturkompensationsverfahren für einen photoleitenden Detektor, der spannungsmäßig über einen Lastwiderstand ausgelesen wird, der in Reihe mit diesem Detektor geschaltet ist, dadurch gekennzeichnet, daß der Lastwiderstand in Form eines Volumens aus demselben Material wie der Detektor und in dessen Nähe hergestellt wird und daß er mit einer isolierenden Abdeckung bedeckt wird, die für die zu messende elektromagnetische Strahlung undurchlässig ist.

2. Verfahren nach Anspruch 1, dadurch gekennzeichnet, daß der Wert des Lastwiderstandes gleich dem Wert des inneren Widerstandes des Detektors ist.

3. Verfahren nach einem der Ansprüche 1 oder 2, dadurch gekennzeichnet, daß die Oberfläche des Lastwiderstandes durch eine wachsende Ähnlichkeitstransformation der Oberfläche des photoleitenden Detektors erhalten wird.

4. Verfahren nach einem der Ansprüche 1 bis 3, dadurch gekennzeichnet, daß der Detektor und sein Lastwiderstand gleichzeitig unter Verwendung der Dünnschichttechnik hergestellt werden.

## Claims

1. Method of temperature compensation of a photoconductive detector for voltage read out, by means of a load resistor mounted in series with said detector, characterized in that the load resistor is embodied as a volume of the same material as the detector, in the neighborhood of the latter, and in that it is covered with an insulating mask opaque to the electromagnetic radiation to be detected.

2. Method according to claim 1, characterized in that the value of the load resistor is equal to the value of the inner resistance of the detector.

3. Method according to any of claims 1 and 2, characterized in that the surface of the load resistor is obtained by an increasing homothetic transformation of the surface of the photoconductive detector.

4. Method according to any of claims 1 to 3, characterized in that the detector and its load resistor are simultaneously formed by using the technique of thin layers.

# FIG_1

$R_D$  $h\gamma$  $\mathcal{D}$  $\dfrac{V}{2} + V_S$  $R_C$

$V$

# FIG_2

$III$  $V_S$  $g$  $V_S$  $V_S$

$+V$

$-V$

$III$  $7$

# FIG_3

$2$  $4$  $1$  $\mathcal{D}$  SUBSTRAT  $8$  $10$  $3$  $R_C$  $7$

1